# EUROPÄISCHE PATENTSCHRIFT

(11) **EP 1 973 668 B1**
(45) Veröffentlichungstag und Bekanntmachung des Hinweises auf die Patenterteilung: **28.04.2010**
(21) Anmeldenummer: 07703440.3
(22) Anmeldetag: 13.02.2007
(51) Int. Cl.: B05B 15/12, B05C 5/00, B05C 9/06, B05C 11/08, B05C 15/00, H01L 21/00

(54) **VORRICHTUNG UND VERFAHREN ZUM GLEICHMÄSSIGEN BESCHICHTEN VON SUBSTRATEN**
APPARATUS AND METHOD FOR THE UNIFORM COATING OF SUBSTRATES
DISPOSITIF ET PROCEDE POUR REVETIR DES SUPPORTS DE MANIERE UNIFORME

(30) Priorität: 17.02.2006 DE 102006007446
(43) Veröffentlichungstag der Anmeldung: 01.10.2008
(73) Patentinhaber: Stangl Semiconductor Equipment AG, 82223 Eichenau (DE); Würth Solar GmbH & Co. KG, 74523 Schwäbisch Hall (DE)
(72) Erfinder: STANGL, Wolfgang, 82223 Eichenau (DE); STANGL, Hans-Jürgen, 78579 Neuhausen o. E. (DE)
(74) Vertreter: Stöckeler, Ferdinand
(86) Internationale Anmeldenummer: PCT/EP2007/001246
(87) Internationale Veröffentlichungsnummer: WO 2007/093390

(56) Entgegenhaltungen:
- GB-A- 1 566 113
- US-A- 3 993 018
- US-A- 4 822 639
- US-A- 4 889 069
- US-A- 5 766 354
- US-A- 5 853 961

## Beschreibung

Die vorliegende Erfindung befasst sich mit einer Vorrichtung und einem Verfahren, die es ermöglichen, eine Oberfläche eines Substrates mit einer Flüssigkeit bzw. einer in einer Flüssigkeit gelösten Substanz gleichmäßig zu bedecken, und insbesondere mit einem Konzept, das es ermöglicht eine chemische Beschichtung auf einem Substrat gleichmäßig aufzubringen. Insbesondere wird das einseitige Beschichten, Ätzen, Reinigen, Trocknen von flächigen Gegenständen wie z.B. plattenförmigen Glasscheiben oder flexiblen Materialien ermöglicht.

Anwendungen, bei denen Trägersubstrate mit einer dünnen Schicht eines zusätzlichen Materials bedeckt werden müssen, sind vielfältig. Dabei kann die zusätzlich aufgebrachte Schicht beispielsweise aktiv sein, also etwa eine optische oder elektrische Funktion besitzen. Beispiele hierfür sind das Aufbringen einer photosensitiven Schicht bei der Produktion von Solarzellen oder das Aufbringen einer dünnen Phosphorschicht auf eine CCD, um diese mit einer Konversionsschicht zu versehen, so dass die CCD in Kombination mit der Konversionsschicht auch auf Röntgenstrahlung sensitiv ist. Bei einer gleichmäßigen Beschichtung mit dünnen Schichten, die keine aktive Funktion ausüben, dient die Beschichtung häufig als mechanischer Schutz, wie es beispielsweise bei Audio-CD's der Fall ist. Hier wird nach Produktion der CD eine Schutzschicht eines transparenten Kunstharzes auf die optisch auslesbare Seite der CCD aufgebracht, um dieselbe vor Beschädigungen zu schützen. Dabei ist es erforderlich, die Schichtdicke der Schutzschicht so gleichmäßig wie möglich über den gesamten CD-Rohling aufzubringen, um die optischen Eigenschaften bezüglich beispielsweise Absorptions- und Reflexionsverhalten einer CCD nicht ortsabhängig zu beeinflussen.

Auch bei dem Aufbringen optisch bzw. elektrisch aktiver Schichten ist die Gleichmäßigkeit der Aufbringung bzw. das Einhalten einer bestimmten Soll-Schichtdicke ein wesentliches Ziel, da die Schichtdicke bzw. die Homogenität derselben unmittelbaren Einfluss auf beispielsweise die optischen oder elektrischen Parameter eines durch Beschichtung erzeugten Bauteils hat.

Bei lithographischen Verfahren, die das Bearbeiten einer Halbleiteroberfläche durch Ätzen beinhalten, ist es wesentlich, dass die Halbleiteroberfläche mit einer gleichmäßigen Dicke von Ätzmittel kontrolliert bedeckt werden kann, so dass der Fortschritt des Ätzens über die gesamte Fläche des zu bearbeitenden Halbleiters mit gleicher Geschwindigkeit erfolgt.

Im Stand der Technik sind verschiedene Verfahren bekannt, eine gleichmäßige Beschichtung einer Oberfläche zu erzielen. Bei CDs wird beispielsweise die zu beschichtende Oberfläche in schnelle Rotation versetzt, wobei dann ein für die Beschichtung verwendetes Material in der Nähe der Rotationsachse aufgebracht wird, so dass das Material durch die Fliehkräfte automatisch auf der Oberfläche der Scheibe verteilt wird, wo es aufgrund von Adhäsionskräften in einer gleichmäßigen Schichtdicke haften bleibt. Weitere bekannte Verfahren sind beispielsweise das galvanische, also das elektrochemische Abscheiden von in einer Flüssigkeit gelöster Ionen auf einer Oberfläche sowie das Besprühen einer Oberfläche bzw. das Tauchen von zu beschichtenden Oberflächen in ein Bad des zur Beschichtung verwendeten Materials.

Bei chemischen Verfahren, die darauf basieren, das zumindest zwei Reagenzien, die das zur Beschichtung verwendete Material durch chemische Reaktion bilden können, auf die Oberfläche eines Substrates aufgebracht werden, so dass sich durch die chemische Reaktion das Material auf der Oberfläche abscheidet, sind eine Reihe weiterer Rahmenbedingungen zu beachten. Zum einen findet die chemische Reaktion, die das Beschichtungsmaterial bildet, nicht nur auf der Oberfläche statt, sondern auch innerhalb des Flüssigkeitsvolumens, das aus den gemischten Reagenzien gebildet ist. Je nach Reaktionsgeschwindigkeit ist es daher zumindest ungünstig bzw. unmöglich, einen großen Vorrat aus vorgemischten Reagenzien vorrätig zu halten, um beispielsweise ein Tauchverfahren durchzuführen, da sich innerhalb des vorgehaltenen Flüssigkeitsvolumens die Reagenzien durch Reaktion gewissermaßen selbst verbrauchen. Dadurch wird zum einen wertvolles Reagens verschwendet, zum anderen ist eine spätere Beschichtung mittels des verbrauchten Reagenzgemisches dann nicht mehr möglich. Das zeitliche Limit für die Verarbeitung erfordert darüber hinaus einen sparsamen Umgang des Reagenzgemisches beim Auftragen auf die zu beschichtende Oberfläche, das Reagenzgemisch, wenn es von der Oberfläche abfließt bzw. entfernt wird nur schwer für eine weitere Verarbeitung wieder verwendet werden kann. Verfahren, bei denen beispielsweise mittels Rotation ein Reagenzgemisch auf der Oberfläche verteilt wird, sind daher nachteilig, da dabei der Großteil des Reagenzgemisches von der Oberfläche entfernt bzw. fortgeschleudert wird.

Ein Verfahren, um ein beschleunigte Reagieren der Reagenzien erst an der Oberfläche des zu beschichtenden Substrates zu erreichen, beschreibt die internationale Patentveröffentlichung WO 03/021648 A1, die einen chemischen Oberflächenbeschichtungsprozess beschreibt, um einen ultradünnen, halbleitenden Film von Gruppe IIB-VIA Komponenten auf einem Substrat zu bilden. Dabei wird eine vorgemischte Flüssigkeitskömposition, die Gruppe IIB und Gruppe VIA Komponente enthält, auf einem beheizten Substrat angebracht; so dass durch die Hitze des Substrates eine heterogene Reaktion zwischen den verschiedenen Gruppenelementen der flüssigen Beschichtung ermöglicht wird. Dabei wird durch die Zuführung von Wärmeenergie die Reaktion an der Oberfläche des Substrates beschleunigt.

Es ist die Aufgabe der vorliegende Erfindung, eine Vorrichtung und ein Verfahren zu schaffen, die es ermöglichen, eine Oberfläche eines Substrates effizienter mit einer Flüssigkeit oder einem Reagenzgemisch gleichmäßiger Schichtdicke zu bedecken.

Diese Aufgabe wird durch eine Vorrichtung gemäß Patentanspruch 1 und durch ein Verfahren gemäß Patentanspruch 18 gelöst.

Der vorliegenden Erfindung liegt dabei die Erkenntnis zugrunde, dass die Oberfläche eines Substrates gleichmäßig mit einer Flüssigkeit bedeckt werden kann, wenn das Substrat in einer Halteeinrichtung fixiert ist, welche mit der Oberfläche des Substrates ein Prozessvolumen bildet, in welches mittels einer Benetzungseinrichtung die Flüssigkeit auf die Oberfläche des Substrates aufgebracht werden kann und wenn darüber hinaus die Halteeinrichtung mit dem Substrat mittels einer Taumeleinrichtung in eine taumelnde Bewegung versetzt wird, so dass sich die Flüssigkeit auf der Oberfläche des Substrates gleichmäßig verteilt. Durch die taumelnde Bewegung wird eine Konzentration des Flüssigkeitsvolumens an einer bestimmten Stelle der Substratoberfläche verhindert, da sich die Bewegungsrichtung der Flüssigkeit ständig verändert. Darüber hinaus kann der Verbrauch von Reagenzien bzw. Flüssigkeiten zur Beschichtung stark reduziert werden, da durch die sich ständig ändernde Bewegungsrichtung der Flüssigkeit auf der Oberfläche des Substrates die Oberfläche gleichmäßig bedeckt wird, ohne dass an den Rändern des Substrates eine große Menge Flüssigkeit durch Herunterfließen von der Substratoberfläche verloren geht.

Erfindungsgemäß wird es also ermöglicht, flächige Gegenstände, wie z.B. plattenförmige Glasscheiben oder flexible Materialien einseitig zu beschichten, zu ätzen, zu reinigen und zu trocknen. Flächige Gegenstände, also Gegenstände, die in einer zu einer ausgedehnten Hauptoberfläche senkrechten Richtung eine geringe Dicke aufweisen, werden nachfolgend zusammenfassend als Substrat bezeichnet. Dies können beispielsweise Glasscheiben, Halbleiteroberflächen oder ähnliche Gegenstände sein, die auch flexibel sein können.

Erfindungsgemäß kann ein solches Substrat beispielsweise mit CdS aus den Reagenzien Ammoniak, Wasser, Kadmiumsulfat- oder -azetat und Thioharnstoff behandelt werden. Darüber hinaus ist die Behandlung mit Zusatzkomponenten, sowie alternativen Reagenzien wie z.B. mit Zn-Azetat möglich.

Bei einem Ausführungsbeispiel der vorliegenden Erfindung wird ein zu bedeckendes Substrat in einer Halteeinrichtung fixiert, wobei das Substrat von der Substratunterseite mittels eines Unterstützungsrahmens gegen eine Prozesskammer der Halteeinrichtung gedrückt wird, welche zusammen mit der Oberfläche des Substrates ein Prozessvolumen bildet. Dabei ist die Prozesskammer so beschaffen, dass diese an den an die Oberfläche des Substrates angrenzenden Rändern Dichtmittel vorsieht, so dass eine auf die Oberfläche des Substrates mittels einer Benetzungseinrichtung aufgebrachte Flüssigkeit von der Oberfläche nicht abfließen kann. Die Halteeinrichtung wird zusammen mit dem von ihr fixierten Substrat von einer Taumeleinrichtung taumelnd bewegt, d.h. der Neigungswinkel der Oberfläche des Substrates bezüglich einer Ausgangslage parallel zur Oberfläche wird kontinuierlich kontrolliert verändert, wobei durch den Einfluss der Schwerkraft die Flüssigkeit auf der Oberfläche des Substrates in sich permanent ändernde Richtungen fließt. Das Taumeln der Oberfläche kann dabei so herbeigeführt werden, dass die Oberfläche bezüglich zweier Achsen, die in einer parallel zur Substratoberfläche verlaufenden Ebene liegen, verkippt wird. Um ein Taumeln in alle Richtungen zu ermöglichen, müssen die beiden Achsen einen Winkel relativ zueinander aufweisen, der beispielsweise 90°C betragen kann.

Die Achsen, bezüglich derer die Ebene verkippt wird, können dabei auch zeitlich variabel sein. Eine Taumelbewegung, also das Verkippen der Ebene, kann beispielsweise dadurch hervorgerufen werden, dass Substrat an 3 Punkten (die eine Ebene definieren) zu unterstützen, wobei die 3 Unterstützungspunkte unabhängig voneinander in einer Richtung horizontal zur Substratoberfläche bewegt werden können.

Durch die permanente Taumelbewegung, die bereits mit Beginn des Benetzens durch die Benetzungseinrichtung erfolgen kann, wird die in das Prozessvolumen eingebrachte Flüssigkeit gleichmäßig verteilt, so dass sich bei chemischer Beschichtung der Oberfläche eine Oberflächenbeschichtung mit einer gleichmäßigen Dickenverteilung einstellt. Durch das Taumeln werden dabei insbesondere auch Randeffekte, die aufgrund von Adhäsionskräften an den Wänden des Prozessvolumens entstehen würden, wenn die Oberfläche lediglich gleichmäßig dünn mit der Flüssigkeit besprüht wird, vermieden. Solche Randeffekte hätten zur Folge, dass an den Rändern des Substrates, wo die Oberfläche des Substrates an die Halteeinrichtung angrenzt, eine dickere Flüssigkeitsschicht auf der Oberfläche des Substrates befindlich wäre als in den zentralen Bereichen des Substrates, so dass eine daraus resultierende Beschichtung dickenmäßig nicht mehr homogen wäre. Dies kann durch die Taumelbewegung auf einfache und effiziente Art und Weise vermieden werden.

Bei einem weiteren Ausführungsbeispiel der vorliegenden Erfindung ermöglicht die Benetzungseinrichtung das gleichzeitige Einbringen unterschiedlicher Flüssigkeiten in das Prozessvolumen, so dass bei einer chemischen Beschichtung die Durchmischung der die Beschichtung bildenden Reagenzien erst unmittelbar im Moment des Benetzens der Oberfläche des Substrates erfolgt, so dass sich keine Effizienzverringerung bzw. Verschwendung der Reagenzien ergibt, wie es der Fall ist, wenn diese bereits vorher vermischt und in einem vermischten Zustand vorrätig gehalten werden.

Um die Zeit des Vermischens weiter zu verringern und somit die Effizienz weiter zu erhöhen, weist die Benetzungseinrichtung bei einem weiteren Ausführungsbeispiel der vorliegenden Erfindung eine Mischeinrichtung auf, in die verschiedene Flüssigkeiten (beispielsweise Reagenzien einer chemischen Beschichtung) vor dem Aufbringen auf die Oberfläche des Substrates fließen, so dass eine schnellere und gleichmäßigere Durchmischung erreicht werden kann.

In anderen Worten kann die Dosierung der auf das Substrat aufgebrachten Reagenzien auf unterschiedliche Art und Weisen durchgeführt werden. Bei einer Einzeldosierung auf das Substrat werden die Chemikalien einzeln der Prozesskammer bzw. dem Prozessvolumen zugeführt. Je nach Prozessanforderungen kann dabei die Reihenfolge der Dosierung und die Länge der Dosierung (die Dosierzeit) festgelegt werden. Bei einer Mischtankdosierung können verschiedene Chemikalien in einem Mischtank vorgemischt und dem Substrat bzw. dem Prozessvolumen zugeführt werden.

Bei einem weiteren Ausführungsbeispiel der vorliegenden Erfindung ist eine Kombidosierung möglich, bei der ein Teil der Chemikalien in einem Mischtank, bzw. einem Mischrohr vorgemischt werden, um vorgemischt der Prozesskammer zugeführt zu werden. Weitere Reagenzien können direkt auf das Substrat aufgebracht werden, bzw. der Prozesskammer zugeführt werden, ohne diese vorher mit anderen Reagenzien zu vermischen. Hierbei kann die Reihenfolge der Zufuhr und die jeweilige Zudosierzeit frei bestimmt bzw. variiert werden.

Darüber hinaus ist es erfindungsgemäß möglich, die Dosierung bei eingeschalteter Taumelbewegung vorzunehmen, um insgesamt die zur Dosierung bzw. Zufuhr der Chemikalien benötigte Zeit effizient zu nutzen.

Für die Dosierung, also die Bestimmung des zugeführten Volumens bzw. der zugeführten Menge (Gewicht oder Ähnliches) der zugeführten Reagenzien können eine Vielzahl von Sensoren bzw. Aggregate verwendet werden, wie beispielsweise eine Wägezelle, ein Schwimmerschalter, ein Flügelraddurchflussmesser oder auch eine Dosierpumpe.

Bei einem weiteren Ausführungsbeispiel der vorliegenden Erfindung ist es darüber hinaus möglich, die zuzuführenden Reagenzien auf eine Temperatur zu bringen, die sich von der Substrattemperatur unterscheidet. Das heißt also, die Reagenzien können gekühlt, bei Raumtemperatur oder geheizt auf das Substrat aufgebracht werden. Daher können je nach den spezifischen Prozessanforderungen alle oder einige verwendete Dosiertechniken wahlweise mit Rührern, Heizungen oder Kühlern ausgestattet sein.

Bei einem weiteren Ausführungsbeispiel der vorliegenden Erfindung ist das durch die Halteeinrichtung gebildete Prozessvolumen gasdicht verschließbar, so dass auch bei der Verwendung von gasenden, gesundheitsschädlichen Reagenzien keine negativen Auswirkungen auf die Umgebung zu befürchten sind.

Bei einem weiteren Ausführungsbeispiel der vorliegenden Erfindung ist die Halteeinrichtung so ausgestaltet, dass die das Prozessvolumen begrenzende Komponente der Halteeinrichtung beim Aufsetzen auf das Substrat eine räumliche Überdeckung mit dem Substrat hat, die 5 % der Oberfläche des Substrates nicht überschreitet, so dass erfindungsgemäß nur ein geringer Bruchteil der zur Verfügung stehenden Substratfläche durch das Abdichten für weitere Prozessschritte unzugänglich gemacht wird.

Bei einem weiteren Ausführungsbeispiel der vorliegenden Erfindung ist die Halteeinrichtung so ausgebildet, dass sie in einem geöffneten Zustand den ungehinderten Zugang zu dem Substrat von zumindest einer Seite der Halteeinrichtung ermöglicht, so dass im geöffneten Zustand der Halteeinrichtung das Substrat sowohl in den Bereich der Halteeinrichtung hinein als auch aus dem Bereich der Halteeinrichtung heraus bewegt werden kann.

Bei einem weiteren Ausführungsbeispiel der vorliegenden Erfindung weist die erfindungsgemäße Vorrichtung zusätzlich eine Heizeinrichtung auf, die ausgebildet ist, um das Substrat auf eine vorbestimmte Heiztemperatur zu erwärmen, so dass durch die zugeführte Wärmeenergie ein chemischer Prozess, der ein zu beschichtendes Material erzeugen kann, hauptsächlich an der Oberfläche des Substrates beschleunigt wird. Dabei wird durch das Taumeln sichergestellt, dass die Konzentration der Reagenzien im Mittel an jedem Punkt der Oberfläche gleich ist, sodass die Reaktionsgeschwindigkeit der Reagenzien an der Oberfläche des Substrates erhöht werden kann, ohne eine lokal erhöhte Schichtdicke beispielsweise am Ort des Einfüllens der Chemikalien zu erhalten. So können unvermeidliche Verluste durch nicht an der Oberfläche des Substrats reagierende Reagenzien weiter verringert werden.

Bei einem weiteren Ausführungsbeispiel der vorliegenden Erfindung wird das Substrat gemeinsam mit der zugeführten Chemikalie hochgeheizt. Das heißt das Substrat wird auf der Heizung verpresst. Die Reagenzien werden dazu gegeben. Die Heiztemperatur liegt dabei noch unterhalb der Starttemperatur für die chemische Reaktion. Dies bedeutet insbesondere auch, dass die Temperatur des Substrats am Anfang geringer oder gleich der Temperatur der Chemikalie ist. Während der Taumelbewegung wird die Heiztemperatur langsam auf den Sollwert erhöht. Dadurch findet ein langsamer Reaktionsstart und eine gleichmäßige Beschichtung statt. Dies ist insbesondere deshalb möglich, da die Temperatur des Substrats im Moment des Einfüllens der Chemikalie noch unter der Reaktionstemperatur der Chemikalie also auch unter der Temperatur der Chemikalie liegt, sodass nicht bereits beim ersten Kontakt der eingefüllten Chemikalie der Beschichtungsvorgang gestartet wird.

Bei einem weiteren Ausführungsbeispiel der vorliegenden Erfindung ist die Haltevorrichtung derart ausgestaltet, dass im geöffneten Zustand von einer Seite der Haltevorrichtung ein Substrat, beispielsweise eine Glasplatte, mittels eines herkömmlichen Handlings, also einer verbreiteten Transporteinrichtung, in die Haltevorrichtung transportiert oder aus dieser heraus transportiert werden kann, so dass die erfindungsgemäße Vorrichtung einfach in bestehende Produktionsanlagen integriert werden kann.

Bevorzugte Ausführungsbeispiele der vorliegenden Erfindung werden nachfolgend, Bezug nehmend auf die beiliegenden Zeichnungen, detailliert erläutert. Es zeigen:
- Fig. 1a-c: ein Ausführungsbeispiel einer erfindungsgemäßen Haltevorrichtung mit Bewegungsrichtung der Taumelbewegung;
- Fig. 2: eine Seitenansicht eines Ausführungsbeispiels einer erfindungsgemäßen Vorrichtung zum gleichmäßigen Beschichten einer Oberfläche; und
- Fig. 3: eine Schnittansicht eines Ausführungsbeispiels einer erfindungsgemäßen Vorrichtung zum gleichmäßigen Beschichten einer Oberfläche eines Substrates;
- Fig. 4: eine weitere Schnittansicht eines Ausführungsbeispiels der vorliegenden Erfindung;
- Fig. 5: eine perspektivische Ansicht eines Ausführungsbeispiels der vorliegenden Erfindung;
- Fig. 6: eine Aufsicht auf ein Ausführungsbeispiel der vorliegenden Erfindung;
- Fig. 7: ein Ausführungsbeispiel für eine erfindungsgemäße Taumeleinrichtung; und
- Fig. 8: eine perspektivische Ansicht eines Ausführungs-beispiels der vorliegenden Erfindung.

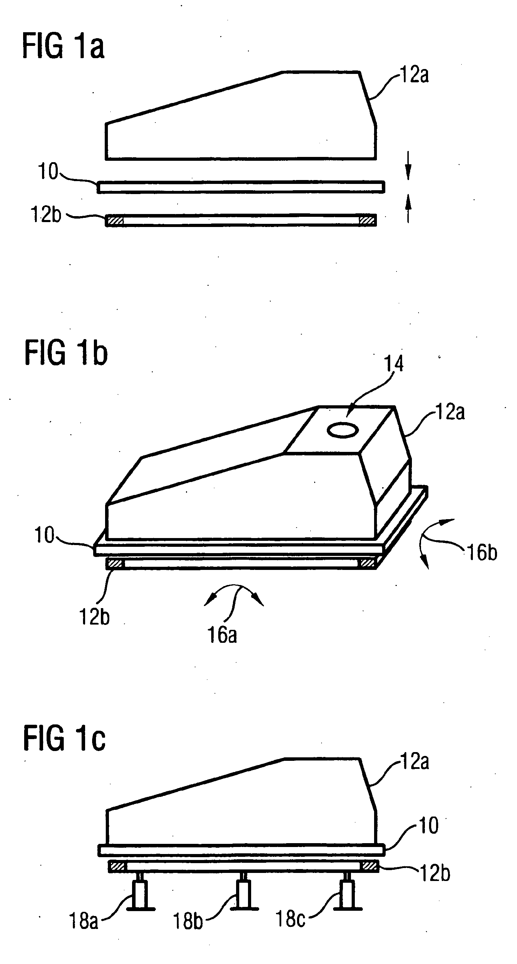

In den Fig. 1a bis 1c ist eine schematische Darstellung der Funktionsweise der erfindungsgemäßen Vorrichtung zum gleichmäßigen Benetzen einer Oberfläche eines Substrates dargestellt.

Die Fig. 1a bis 1c zeigen in einer Seitenansicht und einer perspektivischen Ansicht das Substrat 10 und die Halteeinrichtung, die aus einem Oberteil 12a und einem Unterteil 12b besteht.

Fig. 1a zeigt dabei den geöffneten Zustand der Halteeinrichtung und Fig. 1b und 1c den geschlossenen Zustand derselben.

Wie Fig. 1a zeigt, sind zunächst das Oberteil 12a und das Unterteil 12b der Halteeinrichtung räumlich getrennt, wobei sich zwischen dem Oberteil 12a und dem Unterteil 12b das Substrat 10 befindet, das in der industriellen Anwendung mittels herkömmlichen Substrathandlings dorthin transportiert werden kann.

Im geschlossenen Zustand der Halteeinrichtung, wird das Substrat 10 von dem Untereil 12b gegen das Oberteil 12a gepresst, so dass die zu beschichtende Oberfläche des Substrates 10 (oben) mit dem Oberteil 12a der Halteeinrichtung ein Prozessvolumen bildet, in das durch eine Öffnung 14 (Chemikalien) Chemikalien in das Prozessvolumen auf die Oberfläche des Substrates eingebracht werden können.

Erfindungsgemäß ist die Halteeinrichtung inklusive des Substrates 10 auf einer Taumeleinrichtung fixiert, die die Halteeinrichtung mit Substrat bezüglich zumindest zweier nicht paralleler Achsen verkippen kann, so dass die gesamte Anordnung in eine Taumelbewegung versetzt wird. Die Taumelbewegung zeichnet sich dadurch aus, dass die Anordnung im zeitlichen Mittel weder eine Rotation noch eine Translation erfährt, sondern dass die Ebene, die durch die Oberfläche des Substrates gebildet wird, bezüglich ihrer Ausgangslage in sich kontinuierlich ändernden Orientierungen verkippt wird. Als Beispiel für mögliche Achsen, um die die Kippung zum Erzeugen des Taumelns erfolgen kann, sind zueinander orthogonale Kipprichtungen 16a und 16b lediglich als Beispiel in Fig. 1b angedeutet. Der Taumelmechanismus kann dabei beispielsweise mittels dreier, getrennt voneinander ansteuerbarer, hydraulischer Stempel realisiert werden, wie es in Fig. 1c dargestellt ist.

In Fig. 1c sind als Taumeleinrichtung drei individuell steuerbare Hydraulikzylinder 18a bis 18c dargestellt, die an der Unterseite 12b der Halteeinrichtung ansetzen. Die durch die Ansetzpunkte der Hydraulikzylinder 18a bis 18c definierte Ebene, die parallel zur Oberfläche des Substrates 10 ist, kann nun durch unabhängige Bewegung der einzelnen Hydraulikzylinder in jede beliebige Orientierung gekippt werden, wodurch erfindungsgemäß eine Taumelbewegung der Halteeinrichtung hervorgerufen werden kann.

Vorteilhaft ist dabei, dass zur Beschichtung des Substrates verwendete Chemikalien auch erst während der Taumelbewegung in die Öffnung 14 gegeben werden können, um eine chemische Reaktion erst unmittelbar mit Beginn der Beschichtung zu starten. Dies ist beispielsweise zur Effizientsteigerung der Beschichtung von Glasplatten mit CdS aus den Reagenzien Amoniakwasser, Kadmiumsulfat oder Kadmiumazetat, Thioharnstoff, VE-Wasser von Vorteil.

Ein großer Vorteil der Halteeinrichtung besteht weiters darin, dass mittels des Klemmmechanismus Substrate unterschiedlichster Dicke fixiert werden können, da die Fixierung über den aufgebrachten Druck definiert wird. Eine Justage eines der Dicke des Substrats entsprechenden Abstands ist dadurch nicht erforderlich, was den flexiblen Einsatz auch mit unterschiedlichen aufeinanderfolgenden Substraten ermöglicht.

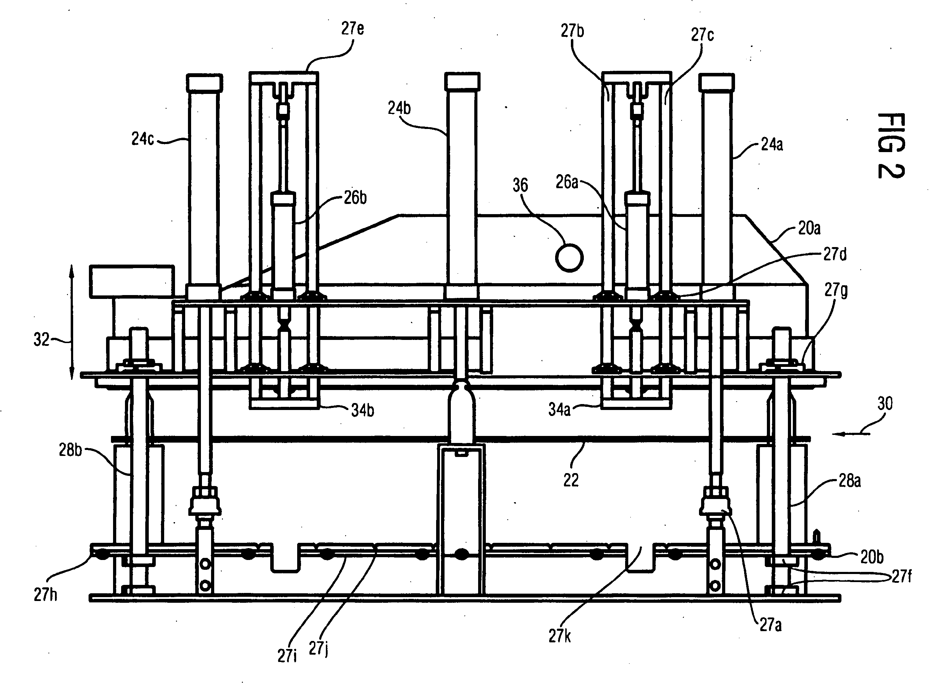

Die Fig. 2 zeigt eine Seitenansicht eines Ausführungsbeispiels einer erfindungsgemäßen Vorrichtung zum gleichmäßigen Bedecken einer Oberfläche eines Substrates. Gezeigt ist ein Oberteil 20a und ein Unterteil 20b einer Halteeinrichtung, wobei das Oberteil 20a zusammen mit dem Substrat die Prozesskammer bildet. Dargestellt ist des Weiteren eine Glasplatte 22, die das zu beschichtende Substrat darstellt, Hydraulikzylinder 24a, 24b und 24c (Zylinder zum Heben-Senken und Verpressen der Prozesskammer) sowie Hilfshydraulikzylinder 26a und 26b (Zylinder für Glasscheibenzentriervorrichtung). Weiterhin sind Führungsstangen 28a und 28b gezeigt, die sicherstellen, dass eine Bewegung des Oberteils 20a der Haltevorrichtung relativ zum Unterteils 20b lediglich in vertikaler Richtung entlang einer genau definierten Achse erfolgen kann.

Die Hydraulikzylinder 24a, b und c sind über die Kolben mit dem Boden verbunden, wobei sich am Ende des dynamischen Verfahrwegs, also am Ende der Hydraulikkolben ein Ausgleichselement 27a befindet. Die Hilfshydraulikzylinder 26a und 26b werden mittels zweier Führungsstangen 27b und 27c stabilisiert, die in einem Führungslager 27d verlaufen, welches ihnen erlaubt, in einer zur Oberfläche des Substrats senkrechten Richtung (einer Bewegungsrichtung 32) verfahren zu werden. Die Hilfshydraulikzylinder 26a und 26b sind über einen Gabelkopf 27e mit den beiden Führungsstangen verbunden.

Fig. 2 zeigt die erfindungsgemäße Vorrichtung zum gleichmäßigen Bedecken einer Oberfläche eines Substrates in geöffneter Position, in welche mittels eines handelsüblichen Substrathandlings in einer Zuführrichtung 30 das Substrat 22 bzw. die Glasscheibe in die Vorrichtung transportiert bzw. aus der Vorrichtung heraus transportiert werden kann. Eine Bewegungsrichtung 32, entlang derer sich das Oberteil 20a relativ zum Unterteil 20b der Haltevorrichtung bewegen kann, wird im Wesentlichen durch die Führungsstangen 28a und 28b festgelegt. Die Führungsstangen 28a und 28b sind auf der einen Seite fest mittels einer Führungsarretierung 27f mit dem Boden verankert. An der anderen Seite werden die Führungsstangen mittels eines Führungslagers 27g, welches relativ zum Oberteil 28 fixiert ist, gehalten. Das Führungslager ermöglicht, dass das Oberteil 20a in der Bewegungsrichtung 32 bewegt werden kann, wobei die Bewegungsrichtung durch die Führungslager und die Führungsstangen 28a und 28b präzise definiert werden kann, so dass die Hydraulikzylinder 24a, 24b und 24c lediglich noch die zur Bewegung erforderliche Kraft erzeugen müssen, ohne jedoch die Richtung der Bewegung selbst exakt definieren zu müssen. Die Glasplatte 22 kann in der Halteeinrichtung fixiert werden, indem diese zwischen das Oberteil 20a und das Unterteil 20b der Halteeinrichtung geklemmt wird. Daher sind an dem Unterteil 20b, auf der der Glasplatte 22 zugewandten Seite, Kunststoffleisten angebracht, um ein Beschädigen der Glasplatte zu verhindern. Darüber hinaus ist auf der Unterseite des Oberteils 20a eine Dichtung vorgesehen, so dass die Glasplatte 22, wenn sie gegen die Oberseite 20a der Halteeinrichtung gepresst wird, zusammen mit dem Oberteil 20a der Halteeinrichtung ein Prozessvolumen definiert, aus dem eine in das Prozessvolumen eingebrachte Flüssigkeit nicht herausfließen kann.

Zum Schließen der Haltevorrichtung wird dabei zunächst die Glasplatte 22 mittels der Hilfszylinder 26a und 26b und an den Hilfszylindern 26a und 26b befindlichen Klauen 34a und 34b angehoben und gegen das Oberteil 20a der Halteeinrichtung gepresst. Der Druck muss dabei nicht so stark sein, dass ein vollständiges Abdichten erzielt wird, da dieser Vorgang lediglich dazu dient, beim darauffolgenden Absenken des Oberteils 20a mit der an das Oberteil gedrückten Glasplatte 22 ein Verrutschen der Glasplatte 22 zu verhindern. Das vollständige Schließen wird dann mittels der Hydraulikzylinder 24a bis 24c erreicht, die das Oberteil 20a absenken, bis dieses auf das Unterteil 20b aufsetzt, so dass die Glassplatte zwischen das Oberteil 20a und 20b geklemmt wird, wobei der Anpressdruck durch die Hydraulikzylinder 24a bis 24c so zu dosieren ist, dass zwischen dem Oberteil 20a und der Glasplatte 22 eine Abdichtung erreicht wird. Nach dem Absenken des Oberteils 20a ist also eine Konfiguration erreicht, in der mittels der Halteeinrichtung ein Substrat 22 bzw. eine Glasplatte so fixiert wird, dass von der Oberfläche des Substrates und der Haltevorrichtung ein Prozessvolumen gebildet wird. Wie bereits erwähnt kommt die Glasplatte 22 dabei auf Kunststoffleisten 27h zu liegen, welche auf einem Auflegerahmen 27i bzw. Auflagerahmen angeordnet sind, welcher die mechanische Last trägt. In den Kunststoffleisten sind ferner Entlüftungsschlitze 27j angebracht, um beim Verpressen der Glasplatte 22 die zwischen der Glasplatte und den Kunststoffleisten eingeschlossene Luft entweichen zu lassen. Ferner sind in den Kunststoffleisten und dem Auflegerahmen Aussparungen für Zentrierfinger 27k vorgesehen, so dass Zentrierfinger, die relativ zum Oberteil 20a fest angeordnet sind, sicherstellen können, dass Oberteil 20a und Unterteil 20b in fester, vorbestimmter Position zueinander verpresset werden. Mittels einer Benetzungseinrichtung bzw. einer Einfüllöffnung 36 kann nun eine Flüssigkeit bzw. ein Chemikaliengemisch in die Prozesskammer auf die Oberfläche des Substrates gegeben werden, um eine Beschichtung vorzunehmen.

Erfindungsgemäß ist die in Fig. 2 dargestellte Halteeinrichtung auf einer Taumeleinrichtung befestigt, die die gesamte Anordnung in eine Taumelbewegung versetzt, um das gleichmäßige Bedecken der Oberfläche der Glasscheibe 22 zu ermöglichen.

Zum Zuführen bzw. Entfernen eines Substrates bzw. einer Glasplatte 20 kann mittels eines konventionellen Substrathandlings das Substrat an einer geeigneten Übergabestelle bzw. mittels geeigneter Maßnahmen (entlang der Scheibenzufuhrrichtung 30) aus der erfindungsgemäßen Vorrichtung entfernt bzw. in diese hinein transportiert werden. Dabei kann die Übergabestelle bzw. das Handling eine handelsübliche Rollenbahn, ein Riemenantrieb oder ähnliches sein. Bevorzugt wird dabei die Gutseite (die zu beschichtende Seite der Glasplatte), welche die Oberseite ist, während des Verfahrens weder mit dem Handling noch innerhalb der erfindungsgemäßen Vorrichtung mechanisch berührt, da diese Glasplatte vorbehandelt sein kann, beispielsweise kann ihr Zustand nass, feucht oder komplett trocken sein.

Wie es in Fig. 2 zu sehen ist, kann ein Handling das Substrat durch eine Frontöffnung (rechts) in die geöffnete Prozessanordnung einbringen. Dabei wird das Substrat zunächst auf Position zwischen dem geöffneten Oberteil 20a und dem Auflagerahmen bzw. dem Unterteil 20b auf eine Halte- und Zentriervorrichtung abgesetzt. Die Zentriervorrichtung fährt dabei bei einem bevorzugten Ausführungsbeispiel der vorliegenden Erfindung die Glasplatte zunächst nach oben und drückt sie an eine rundum laufende Dichtung (Randausschluss). Dadurch kann verhindert werden, dass sich das Substrat 20 beim Absenken und Verpressen der Kammer relativ zu dieser verschiebt. Daraufhin kann die Prozesskammer bzw. das Oberteil 20a abgesenkt und einseitig mit dem Substrat 20 verpresst werden, so dass das Substrat 20 zwischen Oberteil 20a und Auflegerahmen bzw. Unterteil 20b gepresst und mittels einer rundum laufenden Dichtung gegen das Oberteil 20a abgedichtet wird.

Zusätzlich kann mittels Substratheizung die Glasscheibe von unten beheizt werden, wobei das einseitige Durchwärmen des Substrates von unten über eine Heizmatte, einen InfrarotStrahler, einen Umluftheizer, ein Wasserbad oder eine Wärmetauscherplatte, durch welche Kanäle, die mit Heißwasser- oder Öl eines Temperiergeräts Wärme in das System einbringen, realisiert werden.

Während des im Prozessvolumen ablaufenden Prozesses wird die Prozesskammer mittels einer Taumelbewegung bewegt, so dass die Chemikalie gleichmäßig vermischt und an der Oberfläche des Substrates bis zum Randausschluss gleichmäßig verteilt wird. Die in die Prozesskammer von oben über einen statischen Mischer dosiert eingegebene Chemikalie kann auch während der Taumelbewegung, welche die Chemikalie gleichmäßig auf der Oberfläche verteilen soll, dosiert und in das Prozessvolumen gegeben werden.

Bei einem bevorzugten Ausführungsbeispiel der vorliegenden Erfindung wird das Öffnen und Schließen der Prozesskammer, also das Bewegen des Oberteils 20a bzw. des Unterteils 20b pneumatisch durchgeführt. Dabei wird durch die bauliche Anordnung der Hubzylinder eine entlang der Längsseite verlaufende Frontöffnung geschaffen, durch welche ein Substrat in die Prozesskammer (entlang der Scheibenzuführrichtung 30) eingeführt werden kann. Dabei kann diese Zuführung mit handelsüblichen Glasplattenhandlings erfolgen.

Um ein passgenaues Verpressen zu ermöglichen, wird das Substrat von dem Handling beispielsweise auf Zentrierstiften abgelegt, wobei mittels Pneumatikzylindern die Zentrierstifte in exakter Übergabehöhe relativ zum Handling positioniert sein können.

Dabei wird das Handling bevorzugt so ausgeführt, dass dieses nach Ablegen des Substrates auf die Zentrierstifte aus dem Bereich der Prozesskammer nach außen fährt, so dass das Substrat mittels eines pneumatischen Antriebs von den Zylinderstiften nach oben gegen die rundum laufende Dichtung gefahren und leicht verpresst werden kann. Dadurch wird, wie bereits oben erwähnt, beim Absenken des Prozesskammeroberteils 20a ein Verrutschen des Substrates bzw. der Glasplatte 20 verhindert. Beim Absenken des Prozesskammerdeckels 20a wird das Substrat bzw. die Glasscheibe 20 gegen einen Auflegerahmen bzw. gegen das Unterteil 20b gepresst. Dabei sind im Auflegerahmen beispielsweise Nuten eingefräst, um die das Substrat führenden Zylinderstifte zu versenken. Des Weiteren ist der Auflegerahmen beispielsweise mit einer Kunststoffleiste versehen, welche den Anpressdruck egalisiert, wobei darüber hinaus bevorzugt Schlitze im Kunststoffrahmen angeordnet sind, die das Luftpolster unterhalb des Substrates entweichen lassen.

Die Zylinder, die das Anpressen bzw. das Anheben der Glasplatte ermöglichen, können dabei pneumatisch, hydraulisch oder auch über einen Spindelantrieb betrieben sein. Darüber sind auch andere Linearantriebe denkbar. Sollte der Anpresszylinder hydraulisch oder pneumatisch betätigt werden, kann der Anpressdruck beispielsweise über einen analogen Drucksensor überwacht und signalisiert werden. Erfindungsgemäß ist es so möglich, unterschiedliche Substratdicken zu pressen und abzudichten.

Wie bereits erwähnt, muss vor und nach einem Prozess das Substrat an der "unbehandelten Seite" angehoben werden, wobei die beschichtete Seite nicht berührt werden darf. Je nach verwendetem Heizungstyp kommen dabei bevorzugt unterschiedliche Lift- und Zentriervorrichtungen zum Einsatz. Eine mögliche Ausführung ist dabei beispielsweise ein statischer Finger, der um den Auflagerahmen bzw. das Unterteil 20b gekröpft ist. Beim Anheben der Prozesskammer wird die Scheibe automatisch von unten mit angehoben, so dass die Scheibe von unten gegriffen werden kann. Eine äquivalente Anhebung kann auch mittels Zylindern ausgeführt werden.

Das Anheben kann darüber hinaus durch einen Zylinder, der mit einer Feder und einem Aufnahmestößel im Auflagerahmen bzw. Unterteil 20b integriert ist, realisiert werden. Bevorzugt wird der Stößel dabei beispielsweise aus einem Drehteil gefertigt, so dass ein Verdrehen des Zylinders keinen Einfluss auf das Ausheben der Scheibe haben kann.

Bei Substratheizung mittels einer Heizplatte kann beispielsweise unterhalb der Heizplatte an mindestens drei Stellen ein Zylinder montiert werden, der durch die an diesen Stellen mit einer Bohrung versehenen Heizplatte nach oben ausfahren kann, um die Scheibe anzuheben.

Möglich ist auch die Ausführung mittels eines Doppelhubzylinders, der außerhalb der Prozesskammer montiert ist. Bei einem Auffahren der Prozesskammer wird der Doppelhubzylinder beispielsweise so betätigt, dass dieser über vier Hebel seitlich kleine Auflager/Ausleger in den Freiraum unterhalb der Dichtung des Unterteils 20b einschwenken kann. Auf solchermaßen eingeschwenkte Auflager kann das Substrat abgesetzt werden, wobei dann beim Herabsenken der Kammer das Substrat auf Federauflagen übergeben und dadurch zentriert wird. Ein Verpressen der Scheibe wird beispielsweise dadurch ermöglicht, dass die Auflager vor dem Verpressen nach außen schwenken.

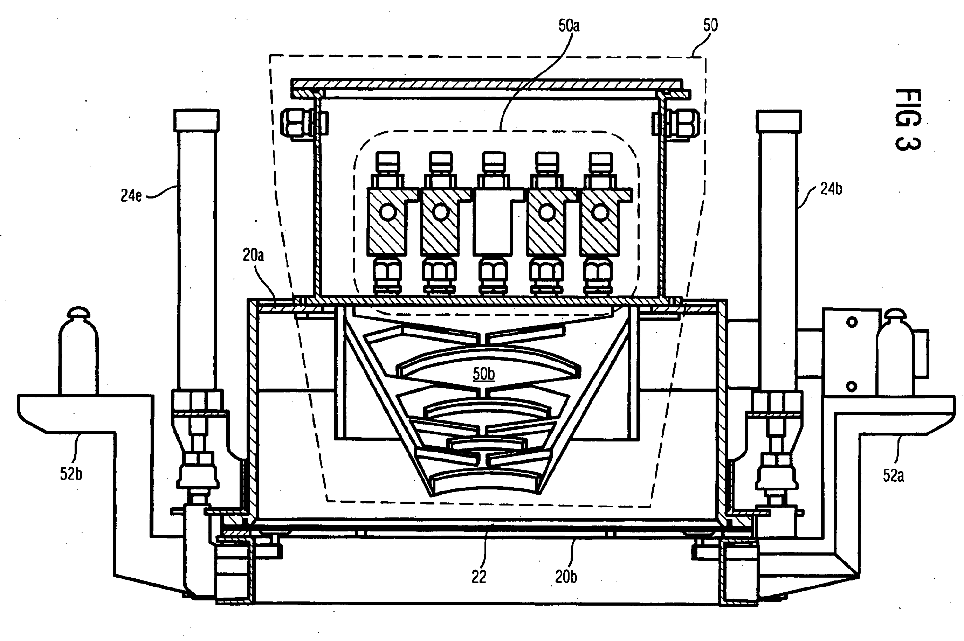

Die Fig. 3 zeigt ein Schnittbild einer Ansicht der erfindungsgemäßen Vorrichtung von Fig. 2, wobei der Schnitt in einer Ebene senkrecht zur Ansicht in Fig. 2 erfolgt und die Schnittebene zwischen dem Hydraulikzylinder 24a und dem Hydraulikzylinder 24b verläuft, wobei die Schnittansicht darüber hinaus so dargestellt ist, dass die Blickrichtung in Richtung des Hydraulikzylinders 24b ist.

Dabei ist die Prozesskammer, die vom Oberteil der Haltevorrichtung 20a begrenzt wird, in geschlossenem Zustand gezeigt, d.h. die Glasplatte 22 ist zwischen dem Oberteil 20a und dem Unterteil 20b der Halteeinrichtung geklemmt. Darüber hinaus ist ein Hydraulikzylinder 24a gezeigt, welcher bereits in der Seitenansicht von Fig. 2 zu sehen ist, und des Weiteren ein Hydraulikzylinder 24d, welcher dem Hydraulikzylinder 24a auf der gegenüberliegenden Seite des Oberteils 20a gegenüberliegt, und der aufgrund der perspektivische der Ansicht von Fig. 2 dort nicht zu sehen ist. Die Anordnung der Hydraulikzylinder ist dabei insbesondere symmetrisch, so dass insgesamt, wie es aus den Fig. 2 und 3 ersichtlich ist, zum Absenken und Anheben des Oberteils 20a sechs Hydraulikzylinder verwendet werden.

Darüber hinaus ist ein Beispiel für eine erfindungsgemäße Benetzungseinrichtung 50 dargestellt, die Einlassventile 50a und einen Mischer 50b (statischer Mischer) umfasst. Mittels der Einlassventile 50a bzw. Ventiltechnik kann eine Mehrzahl unterschiedlicher Reagenzien bzw. Chemikalien in das Prozessvolumen eingebracht werden, wobei in der dargestellten Ausführungsform der vorliegenden Erfindung die Benetzungseinrichtung zusätzlich eine Mischeinrichtung 50b (statischer Mischer) aufweist, um ein Durchmischen der mittels der Ventile 50a in die Mischeinrichtung 50b eingebrachten Flüssigkeiten zu begünstigen und zu beschleunigen. Die Effektivität eines Beschichtungsprozesses wird dadurch erhöht, dass bereits ein homogenes Gemisch auf die Oberfläche der Glasplatte 22 aufgebracht wird, wobei darüber hinaus erfindungsgemäß auf vorteilhafte Art und Weise der Zeitpunkt vom Beginn des Mischvorgangs der unterschiedlichen Chemikalien bis zum Beginn der chemischen Reaktion an der Oberfläche des Substrates, also dem gewünschten Beschichtungsvorgang, möglichst kurz gehalten wird.

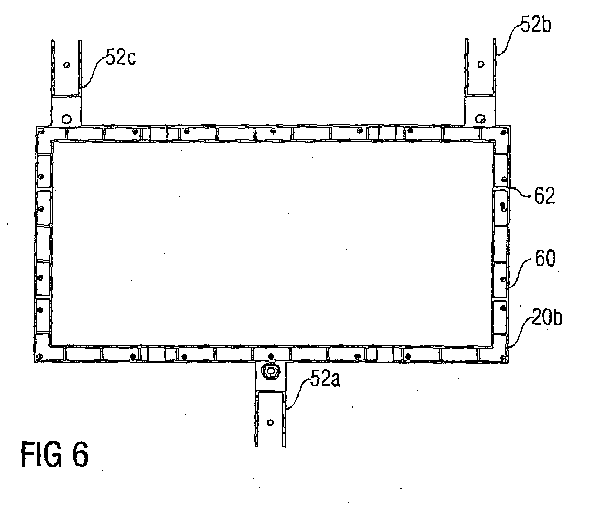

Fig. 3 zeigt zudem einen ersten und einen zweiten mechanischen Ausleger 52a und 52b, wobei die Ausleger 52a und 52b als mechanische Angriffspunkte einer Taumeleinrichtung dienen, um das Taumeln der gesamten in Fig. 3 gezeigten Anordnung zu ermöglichen und wobei diese bezüglich einer Richtung senkrecht zur Schnittrichtung versetzt zueinander angeordnet sind, so dass mittels dreier, versetzt zueinander angeordneter, mechanischer Ausleger das Taumeln erreicht werden kann, wie es im Folgenden anhand der Figuren 6 bis 8 noch näher erläutert werden wird.

Für die Mischeinrichtung bzw. die Benetzungseinrichtung 50 kommen je nach Anforderung des Prozesses unterschiedliche Dosiertechniken in Frage. Prinzipiell können dabei alle in Frage kommenden Dosiertechniken wahlweise mit Rühren oder Heizungen ausgestattet werden, wozu beispielsweise bevorzugt zur Dosierung handelsübliche Sensoren- und Aggregate verwendet werden, wie z.B. Wägezellen, Schwimmerschalter, Flügelraddurchflussmesser und Dosierpumpen.

Dabei kann ein Konzept zur Einzeldosierung verfolgt werden, bei dem also die Chemikalien der Prozesskammer einzeln zugeführt werden, wo sie eventuell über den statischen Mischer 50b innerhalb der Prozesskammer vor Auftreffen auf dem Substrat vermischt werden.

Ebenso ist eine Mischtankdosierung möglich, wobei zumindest teilweise die Chemikalie in einem Mischtank vorgemischt und der Prozesskammer zugeführt wird. Dabei können zusätzliche einzelne Chemikalien der Mischung mittels des statischen Mischers 50b unterhalb des Chemikalieneinlaufstutzens zugegeben werden. Alle Mischerverfahren können zusätzlich auch bei bereits eingeschalteter Taumelbewegung erfolgen können.

Zusammengefasst handelt es sich bei der vorliegenden Erfindung also um eine Vorrichtung und ein Verfahren zum Beschichten, Ätzen, Reinigen, Trocknen von flächigen Gegenständen, wie z. B. plattenförmigen Glasscheiben. Das erfindungsgemäße Konzept ist dabei beispielsweise dafür geeignet, Glasplatten mit CdS aus den Reagenzien Amoniakwasser, Kadmiumsulfat- oder Kadmiumazetat, Thioharnstoff, VE-Wasser und eventueller Zusatzkomponenten zu ermöglichen. Flächige Gegenstände wie Glasplatten sind dabei im Folgenden allgemein als Substrate benannt.

Dabei ermöglicht es die vorliegende Erfindung, kostengünstig und umweltschonend einseitige Beschichtungen mit geringem Randausschluss vorzunehmen, wobei darüber hinaus unterschiedlichste Substratdicken verarbeitet werden können, ohne eine aufwendige mechanische Anpassung an die unterschiedlichen Substratdicken vornehmen zu müssen.

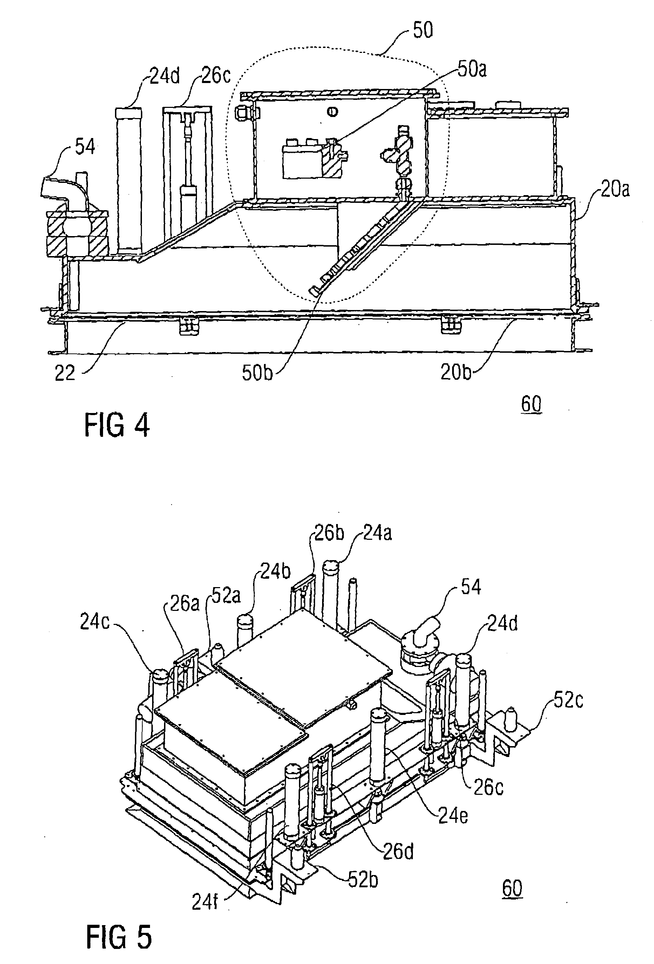

Die Fig. 4 zeigt eine weitere Schnittansicht des in Fig. 3 gezeigten Ausführungsbeispiels der vorliegenden Erfindung, wobei der Schnitt der in Fig. 4 gezeigten Ansicht in einer Schnittebene senkrecht zur Ebene der Ansicht von Fig. 3 verläuft und der Schnitt zentral durch die in Fig. 3 gezeigte Vorrichtung durchgeführt wird, wobei die Blickrichtung so gewählt ist, dass sie vom Hydraulikzylinder 24b in Richtung des Hydraulikzylinders 24e weist. Dabei sind baugleiche Elemente, die bereits in Fig. 3 gezeigt sind, mit den selben Bezugszeichen versehen. Somit sind auch die Beschreibungen der einzelnen Komponenten aus den Fig. 3 und 4 wechselseitig aufeinander anwendbar.

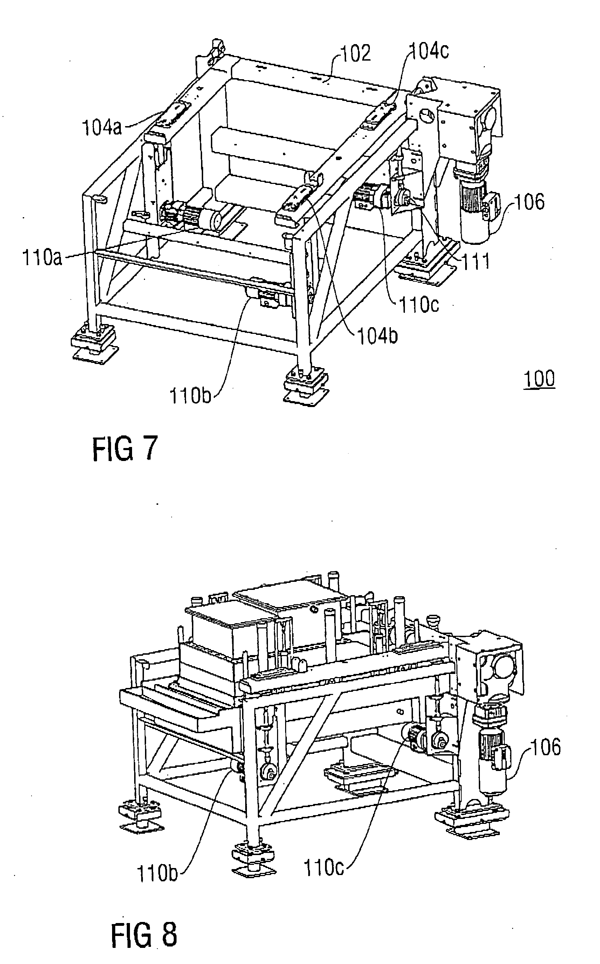

Zusätzlich zu den in Fig. 3 gezeigten Komponenten zeigt Fig. 4 einen Hydraulikzylinder 24d und einen Hilfshydraulikzylinder 26c, welche aus perspektivischen Gründen in den Fig. 2 und 3 nicht sichtbar sind, die aber die selbe Funktionalität haben, wie die bereits anhand der Fig. 2 und 3 beschriebenen Hydraulikzylinder 24a bis c bzw. 26a und b. Die Fig. 4 zeigt darüber hinaus ein Entleerventil 54, das zum Entfernen der in das Prozessvolumen eingebrachten Chemikalien verwendet werden kann, wenn ein Prozessmodul 60, wie es anhand von Fig. 4 dargestellt ist, bezüglich einer Achse, die senkrecht zur Oberfläche der Schnittansicht verläuft, verkippt wird. Sobald der Kippwinkel bei einer Kippung nach links 90° übersteigt, kann das im Prozessvolumen befindliche Chemikaliengemisch durch das Entleerventil 54 ablaufen. Bei einem Ausführungsbeispiel der vorliegenden Erfindung, das im Folgenden anhand der Fig. 7 und 8 beschrieben wird, ist daher ein Verkippmechanismus vorgesehen, der das Verkippen der Prozessanordnung 60 ermöglicht.

Ist das Prozessende erreicht, also beispielsweise das Beschichten oder das Ätzen beendet, kann die Prozessanordnung 60 also durch Schwenken um > 90° entleert werden. Dabei kann durch das Schwenken beispielsweise auch die Wartung von der Rückseite der Prozessanordnung, d.h. also von der Unterseite 20b aus ermöglicht werden. Zusätzlich kann nach dem Entleeren ein Spülen und Vortrocknen der Kammer vorgesehen werden, wozu in das Prozessvolumen weisende Düsen montiert werden können, die beispielsweise im Zustand, in dem die Kammer zum Ausleeren gekippt ist, ein Spülmittel in die Kammer einbringen. Nach dem Spülvorgang wird die Kammer dann zurückgeklappt. Die Zentriervorrichtung kann daraufhin mit dem Unterteil 20b nach unten fahren und die Glasplatte 22 für ein Handlingsystem freigeben. Dabei kann das Substrat beim Herausnehmen aus der Prozessanordnung 60 beispielsweise zusätzlich durch einen Luftmesser gezogen dabei und vorgetrocknet werden, wobei zu beachten ist, dass die Gut-Seite des Substrates (oben) nicht durch Komponenten des Handlings berührt werden darf.

Das Spülen der Prozesskammer kann dabei beispielsweise mittels eines am Deckel fest montierten Spülventils durchgeführt werden. Darüber hinaus sind Sprühdüsen möglich, die im Deckel der Prozesskammer integriert sind, wobei diese an verschiedenen Stellen an der Unterseite des Oberteils 20a montiert werden, so dass ein gleichmäßiges Spülen sichergestellt ist.

Fig. 5 zeigt eine dreidimensionale Ansicht eines Ausführungsbeispiels der vorliegenden Erfindung, welches bereits anhand der Fig. 2 bis 4 beschrieben wurde. Dabei sind für identische Komponenten die selben Bezugszeichen vergeben, so dass die Beschreibung der betreffenden Komponenten aus den Fig. 2 bis 5 wechselseitig aufeinander anwendbar ist. Dabei soll insbesondere im Folgenden lediglich kurz auf diejenigen Komponenten eingegangen werden, die anhand der Fig. 2 bis 4 noch nicht beschrieben wurden.

Dabei sind in der dreidimensionalen Ansicht sowohl ein Hydraulikzylinder 24f als auch ein Hilfshydraulikzylinder 26d dargestellt, die aufgrund der in den Fig. 2 bis 4 verwendeten Perspektiven in diesen Figuren durch andere Bauteile verdeckt wurden.

Darüber hinaus zeigt die Fig. 5 drei mechanische Ausleger 52a, 52b und 52c, die als mechanische Aufnahme der Prozessanordnung 60 dienen, um das Taumeln zu ermöglichen. Die durch die drei mechanischen Ausleger 52 definierte Ebene ist parallel zur Ebene des Substrates bzw. der Glasplatte 22, so dass die Taumelbewegung der Prozessanordnung 60 dadurch herbeigeführt werden kann, dass die Prozessanordnung 60 an den mechanischen Auslegern gehalten bzw. unterstützt wird, wobei die Prozessanordnung an den drei Punkten unabhängig voneinander auf und ab bewegt werden kann, so dass sich durch die Überlagerung der Bewegungen die Taumelbewegung der Prozessanordnung 60 ergibt.

Eine Prozessanordnung 60, wie sie anhand von Fig. 5 dargestellt ist, besteht also im Wesentlichen aus einem statischen Mischer 50b, aus Pneumatik und Elektrik zur Steuerung bzw. Bewegung, einem Entleerventil 54, Dosierventilen 50a, einer umlaufenden Dichtung Entlüftungsventilen sowie einer Zuführmöglichkeit für Chemikalien. Zusätzlich ist der in Fig. 2 bereits beschriebene Auflegerahmen dargestellt, auf dem das Substrat abgelegt wird, bzw. mit dem das Substrat verpresst wird. Die Pneumatik und Elektrik sowie der statische Mischer sind in der 3-dimensionalen Ansicht von Fig. 5 nicht sichtbar, da diese sich in einem abgeschlossenen, von Deckeln verschlossenen Volumen befinden.

Die Chemikalien können dabei mittels der Dosierventile 50a aus Dosiertanks dosiert werden. In den beschriebenen Ausführungsbeispielen sind die Dosierventile 50a dabei oberhalb des statischen Mischers 50b angeordnet, so dass die Chemikalie unter dem Einfluss der Schwerkraft dem freien Gefälle folgend bei geschlossener Prozesskammer auf das Substrat bzw. die Glasplatte 22 dosiert werden kann. Dabei ist es insbesondere vorteilhaft, dass es sich um ein geschlossenes System handelt, in welchem keine Chemikaliendämpfe nach außen treten können. Darüber hinaus kann beim erfindungsgemäßen Ausführungsbeispiel die Taumelbewegung bereits während der Dosierung gestartet werden.

Dabei können die Dosierventile 50a beispielsweise als 4-Wege-Ventile ausgeführt werden. Dadurch kann beispielsweise nach jeder Chemikaliendosierung mit N2 gespült werden, um eine Querreaktion im Chemikalienzulauf zum Mischer zu verhindern. Ein dritter Anschluss des 4-Wege-Ventils kann dabei beispielsweise zum Spülen mit VE-Wasser genutzt werden, während die Prozesskammer bzw. die Prozessanordnung 60 gekippt ist. So kann die komplette Zuführung bzw. Chemikalienzuführung von Chemikalienresten freigespült werden.

Ein Vorteil der erfindungsgemäßen Prozessanordnung 60 besteht darin, dass der statische Mischer 50b die Chemikalien miteinander vermischt, bevor diese auf die Substratoberfläche treffen, wodurch Flecken auf der Substratoberfläche vermieden werden. Dabei können die Chemikalien beispielsweise mittels flexibler Schläuche aus Dosiertanks an die Prozessanordnung geführt werden, wobei die Dosiertanks extern angeordnet sein können. Dabei kann darüber hinaus eine gezielte Entlüftung des Systems durch ein Entlüftungsventil gewährleistet werden und die Dosierventile können aus Sicherheitsgründen in ein Gehäuse eingebaut werden, wie es in den Fig. 3 bis 5 dargestellt ist. Obwohl aufgrund der Taumelbewegung mit einem sehr geringen Chemikalienverbrauch eine gleichmäßige Benetzung an der Substratoberfläche erzielt werden kann, werden nach Beendigung des Prozesses überschüssige Chemikalien im Prozessvolumen verbleiben. Diese können beispielsweise durch das Entleerventil 54 aus der Kammer entfernt werden, wenn die Prozessanordnung 60 um einen Winkel > 90° gekippt ist. Zusätzlich können im Oberteil 20a bzw. im Deckel der Prozesskammer Sprühdüsen zum Freispülen der Kammer von der Chemikalie angeordnet werden.

Dabei ist in das Oberteil 20a der Kammer an der Grenzfläche zwischen Substrat und Oberteil in einem bevorzugten Ausführungsbeispiel der vorliegenden Erfindung eine rundumlaufende Dichtung eingearbeitet. Diese dichtet die umherschwappende Chemikalie gegen außen ab, was gleichzeitig auch für die zu verwendende Spülflüssigkeit gilt. Für die pneumatische Ansteuerung und die elektrische Steuerung kann ein Pneumatik/Elektrokabinett in unmittelbarer Nähe neben den Ventilen und den Zylindern der Hydraulik montiert werden. Kurze Signalwege garantieren dann ein gleichmäßiges Ansteuern der Zylinder und Ventile.

Das Prozesskammergehäuse selbst, also der Teil des Gehäuses, der das Prozessvolumen bildet, kann dabei beispielsweise aus einem aus Edelstahl bestehenden Grundrahmen mit angebautem Verpressmechanismus bestehen. Dabei kann das Prozesskammergehäuse abhängig von den zu verwendenden Chemikalien und Temperaturen beispielsweise mit Kunststoff oder Halar beschichtet sein. Dabei kann eine bevorzugt an der Unterseite des Oberteils 22b angebrachte Dichtung in das Prozesskammergehäuse eingefräst sein, wobei bei hohen Verarbeitungstemperaturen die Dichtung bevorzugt im Edelstahl-Rahmen eingefräst und beschichtet ist. Bei niedrigeren Temperaturen kann dieselbe auch in einen Kunststoffrahmen eingefräst bzw. an einem solchen befestigt sein, wobei der Kunststoffrahmen mit der Innenauskleidung verschweißt- oder verschraubt ist. Die eventuell für die mechanische Stabilität des Prozesskammergehäuses erforderliche Versteifungsstreben können entweder aus Edelstahl oder beispielsweise aus mit Kunststoff oder Halar beschichtetem Edelstahl bestehen. Zur Kontrolle des Prozesses kann darüber hinaus im Deckel des Prozesskammergehäuses ein Fenster bzw. ein Sichtdeckel, der von oben auf dem Rahmen mittels Dichtung verschraubt ist, angebracht sein. Der Auflagerahmen bzw. das Untereil 20a kann beispielsweise ebenfalls aus einem Edelstahlprofil hergestellt sein, wobei in einem bevorzugten Ausführungsbeispiel das Edelstahlprofil Belüftungsschlitze aufweist, um eventuell beim Schließen der Prozessanordnung 60 auftretende Druckunterschiede zu verhindern. Darüber hinaus kann der Auflagerahmen mit einer Dichtung versehen sein, die beispielsweise innerhalb von Fräsungen angeordnet ist. Solche, beispielsweise aus PP oder Gummi bestehenden Dichtungen, dienen dabei zum einen dem Schutz der Rückseite des Substrates und können darüber hinaus so beschaffen sein, dass sie Luft entweichen lassen.

Um die Funktionsweise der mechanischen Ausleger 52a bis 52c näher zu verdeutlichen, die für das Erzielen einer erfindungsgemäßen Taumelbewegung notwendig sind, ist in Fig. 6 eine Aufsicht auf ein Beispiel eines erfindungsgemäßen Auflagerahmens bzw. Unterteils 20b dargestellt. Die Aufsicht zeigt dabei das Untereil bzw. den Auflagerahmen 20b, auf dem das Substrat bzw. die Glasscheibe 20 zu liegen kommt. Am Auflagerahmen 20b sind die drei mechanischen Ausleger 52a bis 52c auf verschiedenen Seiten des Auflagerahmens 20 angebracht.

Im in Fig. 6 gezeigten Ausführungsbeispiel eines erfindungsgemäßen Auflagerahmens 20b sind auf der Oberseite des Auflagerahmens 20b zusätzlich Kunststoffleisten angebracht, um das auf dem Auflagerahmen 20b abgelegte Substrat vor Beschädigung zu schützen. Darüber hinaus sind zwischen den Kunststoffleisten Entlüftungsschlitze 62 vorgesehen, die verhindern, dass beim Absenken des Substrates ein Überdruck zwischen Substrat und Auflagerahmen 20b gebildet werden kann.

Durch die geometrische Anordnung der mechanischen Ausleger 52a bis 52c (Ausleger für Kippmechanismus und Wobbling) wird von diesen an drei Punkten eine Ebene definiert, welche parallel zur Ebene des Substrates ist. Erfindungsgemäß kann am Auflagepunkt eines jeden der mechanischen Ausleger 52a bis 52c eine individuell steuerbare Vorrichtung angebracht werden, die eine Bewegungsrichtung senkrecht zur Ebene der Ansicht von Fig. 6 hat, so dass an den drei Punkten, die durch die mechanischen Ausleger 52a - 52c definiert werden, die Ebene und mit ihr das Substrat bewegt bzw. verkippt werden kann, wodurch eine Taumelbewegung beliebiger Orientierung erreicht wird. Fig. 6 zeigt ferner einige Ausführungsdetails, wie beispielsweise die bereits beschriebenen Entlüftungsschlitze 62 in Aufsicht und Schraubenlöcher bzw. Schrauben zum Haltern der Kunststoffleiste bzw. Kunststoffleisten 60.

Die Fig. 7 zeigt ein Ausführungsbeispiel der vorliegenden Erfindung, bei dem die Taumelbewegung mittels eines Grundgestells 100 erreicht werden kann, an dem beispielsweise eine erfindungsgemäße Prozessanordnung 60 mittels der mechanischen Ausleger 52a bis 52c befestigt werden kann.

Das Grundgestell 100 weist dabei eine Kippachse 102 sowie drei Verriegelungseinrichtungen 104a bis 104c auf, die zu den mechanischen Auslegern 52a bis 52c korrespondieren und die zum Verbinden des Grundgestells 100 mit einer erfindungsgemäßen Prozessanordnung 60 geeignet sind. Das Grundgestell 100 kann mit der Prozessanordnung 60 mechanisch starr verbunden werden, wenn die mechanischen Ausleger 52a bis 52c auf den Verriegelungseinrichtungen 104a bis 104c (Kipp-Verriegelung der Prozesskammer) angeordnet sind. Bei einer mechanisch starren Verbindung dient ein Kippmotor 106 (Motor zum Kippen der Kammer > 90°) dazu, eine Rotation der Kippachse 102 (Kipparm) zu verursachen und somit die gesamte, an den Verriegelungseinrichtungen 104a bis 104c befestigte Prozessanordnung 60 von der Horizontalen in die Vertikale und darüber hinaus zu verkippen. Dadurch kann zum einen erfindungsgemäß das Entleeren des Prozessvolumens über das Entleerventil 54 erreicht werden, zum andern kann die gesamte Prozessanordnung 68 um 180° in die Horizontale gedreht werden, so dass diese von der Unterseite her für eventuelle Wartungsarbeiten zugänglich wird.

Weiters dient das Grundgestell 100 dazu, die Taumelbewegung der im Grundgestell befindlichen Prozessanordnung 60 zu verursachen. Um das Taumeln hervorzurufen, wird die mechanisch starre Verbindung zwischen den mechanischen Auslegern 52a bis 52c und den Verriegelungseinrichtungen 104a und 104c gelöst, so dass die Prozessanordnung gewissermaßen lose auf dem Grundgestell 100 aufliegt. Das Taumeln wird, wie bereits oben beschrieben, dadurch erreicht, dass an den mechanischen Auslegern 52a bis 52c jeweils eine unabhängige Bewegung senkrecht zur Oberfläche des Substrates bzw. der durch die mechanischen Ausleger 52a bis 52c gebildeten Ebene, vorgenommen wird. Dies wird beim Ausführungsbeispiel der vorliegenden Erfindung dadurch erreicht, dass im Grundgestell 100 unterhalb einer jeden Verriegelung ein Motor 110a bis 110c (Antrieb Wobbling) angebracht ist, an dessen Motorachse eine Exzenterscheibe (Exzenterscheibe Wobbling) befestigt ist. Ähnlich der Pleuelstange beim Verbrennungsmotor eines PKW ist am Radius der Exzenterscheibe eine Vorschubstange befestigt, so dass durch die exzentrische Bewegung die Vorschubstange eine periodische Bewegung senkrecht zur Substratoberfläche bzw. senkrecht zur Ebene, die durch die mechanischen Ausleger 52a bis 52c gebildet wird, ausführt. So kann beispielsweise eine gleichmäßige Wobbel- bzw. Taumelbewegung hervorgerufen werden, wenn die Exzenterscheibe an den Motoren 110a bis 110c so angebracht sind, dass jede Stößelstange den maximalen Hub zu einem anderen Zeitpunkt erreicht.

Das Grundgestell 100 dient also zur Aufnahme des Kippmechanismus und zum Hervorrufen der Taumelbewegung. Dabei kann das Grundgestell darüber hinaus in ein Gehäuse aus Kunststoff montiert werden, um das Austreten von Chemikalien zu behindern. Wie es in Fig. 7 zu sehen ist, ist das Grundgestell darüber hinaus mit Justierfüßen ausgestattet, die ein komplettes horizontales Ausrichten der Einheit erlauben. Die Taumelbewegung wird mit drei Motoren 110a bis 110c realisiert, welche über je eine Exzenterscheibe die Prozesskammer bzw. die Prozessanordnung 60 taumeln lassen. Dabei führen aufgrund ihrer geometrischen Ausbildung die Exzenterscheiben eine Sinusbewegung durch, wobei der Hub der Bewegung durch Variation der Exzenterscheiben bzw. geeignete Einstellung derselben mechanisch stufenlos verstellbar sein kann, so dass sich die absolute Taumelhöhe einer der erfindungsgemäßen Prozessanordnung 60 einstellen lässt. Der Kippmotor 106 zum Kippen der Prozesskammer kann die Prozessanordnung um beispielsweise bis zu 180° verkippen. Dabei wird bei einem Kippwinkel >90° die Prozesskammer entleert, bei 180° kann die Prozesskammer von hinten bzw. unten gewartet werden, d.h. Dichtungen können getauscht und die Prozesskammer kann gereinigt werden. Dabei kann der Antrieb der Kippvorrichtung zusätzlich beispielsweise pneumatisch oder hydraulisch ausgeführt sein.

Die Verriegelungseinrichtungen 104a bis 104c dienen zum mechanischen Ver- und Entriegeln der Prozessanordnung 60. Dabei ist während der Taumelbewegung ein Schlitten geöffnet und die Prozesskammer bzw. die Prozessanordnung 60 liegt lose auf drei Stößeln der exzentrischen Prozessbewegung auf. Dadurch ist eine gleichmäßige Taumelbewegung gewährleistet, wobei darüber hinaus die Position der Exzenterscheiben bzw. der Führungs- oder Stößelstangen sensorisch überwacht werden kann.

Nach Beendigung der Taumelbewegung kann die Prozesskammer in Null-Stellung, also in eine horizontale Position, gefahren und mit den drei Verriegelungseinrichtungen 104a bis 104c verriegelt werden, wobei die erfolgreiche Ver- bzw. Entriegelung ebenfalls sensorisch überwacht werden kann.

Fig. 8 zeigt eine erfindungsgemäße Prozessanordnung 60, in einem in das Grundgestell 100 eingebauten Zustand, um zu verdeutlichen, wie die Prozessanordnung mittels des Kippmotors 106 als Ganzes verkippt werden kann und wie darüber hinaus die Taumelbewegung mittels der Motoren 110a bis 110c, die auf Exzenterscheiben wirken, hervorgerufen werden kann.

Es ist darüber hinaus mittels des erfindungsgemäßen Konzepts möglich, auf Basis der in Fig. 8 gezeigten Anordnung ein modulares Anlagenkonzept zu realisieren, welches aus sogenannten Prozessmodulen besteht, die die in Fig. 8 gezeigte Anordnung umfassen. Dabei kann jedes Modul als eigenständiges Prozessmodul verwendet werden und beispielsweise innerhalb einer Lagerhalle an beliebigen Orten angeordnet werden. Jedes solcher Prozessmodule ist dann mittels eines handelsüblichen Substrathandlings, welches eventuell auf die prozesstechnischen Bedürfnisse zusätzlich angepasst ist, mit Substratplatten bzw. Glasplatten zu versorgen. Das Handling transferiert die Glasplatten innerhalb der in Fig. 8 gezeigte Anordnung und entnimmt eine Glasplatte nach Ende eines Prozesses aus derselben. Dabei kann die Materialwahl sowohl des Handlings als auch der das Substrat berührenden Komponenten der Prozessanordnung 60 an die prozesstechnischen Bedürfnisse angepasst werden. Materialien, die verwendet werden können, sind beispielsweise Edelstahl, Kunststoff sowie Kunststoff-ummantelte Edelstahlteile, welche beispielsweise Tropfwannen oder Einhausungen bilden können.

Ein modulares Prinzip hat dabei den Vorteil, dass einzelne Prozessmodule außer Betrieb genommen werden können, während sich andere noch im Produktionsbetrieb befinden. Dabei ist insbesondere durch die Kippvorrichtung ein Warten einzelner Module möglich, ohne dass weitere, eventuell noch in Produktion befindliche Module behindert werden. Eine erhöhte Flexibilität ergibt sich dabei dadurch, dass einzelne Module in beliebiger Reihenfolge und Anzahl aufgebaut werden können, wobei die Taktzeit unter anderem auch durch die Anzahl der verwendeten Module bestimmt wird. Dosierstationen, also Stationen, welche die Chemikalien zuführen, können dabei entweder eigenständige Einheiten sein, die mehrere Module gleichzeitig versorgen oder in die einzelnen Module integriert werden.

Auch beim modularen Aufbau kann die Be- und Entladung der Prozesskammern mit Substraten über handelsübliche Handlingsysteme erfolgen. Zum Einsatz können dabei beispielsweise mehrachsige Linearachsen, Roboter, Rollenbahnen, Bandförderer, rundtaktische und Vakuumgreifen kommen.

Obwohl die Funktionsweise des erfindungsgemäßen Konzepts im Vorhergehenden hauptsächlich anhand des Beispiels einer Glasscheibe beschrieben wurden, können beliebige Substrate, wie beispielsweise PCBs, mittels des erfindungsgemäßen Konzepts auf vorteilhafte Art und Weise beschichtet werden.

Insbesondere ist die Art des Substrathandlings, also der Art und Weise, wie zu beschichtende Substrate innerhalb der erfindungsgemäßen Vorrichtung positioniert werden können, für das erfolgreiche Anwenden des erfindungsgemäßen Konzeptes unerheblich. Die in den Beschreibungen der Ausführungsbeispiele der vorliegenden Erfindung genannten Chemikalien sind exemplarisch zu verstehen. Das erfindungsgemäße Konzepte eignet sich insbesondere auch zum Ätzen von Oberflächen, wobei ein gleichmäßiges Aufbringen einer Ätzflüssigkeit ebenso relevant ist, um erfolgreich einen gleichmäßigen Ätzprozess über ein großflächiges Substrat durchzuführen.

Anhand der beschriebenen Ausführungsbeispiele wurde das Erzeugen einer Taumelbewegung von drei individuell ansteuerbaren Hydraulikzylindern oder mittels von Motoren angetriebenen Exzenterscheiben realisiert. Selbstverständlich sind beliebige andere Möglichkeiten, eine taumelnde Bewegung zu erzeugen ebenso geeignet, um das erfindungsgemäße Konzept erfolgreich umzusetzen.

Die Hydraulikzylinder, die in den beschriebenen Ausführungsbeispielen der vorliegenden Erfindung dazu dienen, die Substrate anzuheben bzw. die Haltevorrichtung zu schließen, können durch jedwede anderen mechanischen Mechanismen ersetzt werden, die ein Anpressen bzw. ein Anheben eines Substrates ermöglichen.

Obwohl in den Ausführungsbeispielen, die im Vorhergehenden diskutiert wurden, die vollständige Halteeinrichtung mit in der Halteeinrichtung fixiertem Substrat bezüglich der Erdoberfläche (Horizontalen) in eine Taumelbewegung versetzt wurde, ist es alternativ auch möglich, nur das Substrat in eine Taumelbewegung zu versetzen, wobei dann zusätzlich durch geeignete Maßnahmen sichergestellt werden kann, dass die auf der Oberfläche des Substrats befindliche Flüssigkeit nicht von der Oberfläche abfließen kann. Beispielsweise wäre die Abdichtung mittels eines flexiblen Faltenbalgs aus Gummi denkbar, so dass das Oberteil der Halteeinrichtung im Wesentlichen starr verbleiben kann und lediglich das Untereil, auf dem der Faltenbalg und das Substrat befestigt sind, die Taumelbewegung durchführt.

Ein vollständiges Abdichten des Prozessvolumens ist darüber hinaus nicht zwingend erforderlich.

Der Erfindung umfasst eine Vorrichtung zum gleichmäßigen Bedecken einer Oberfläche eines Substrates mit einer Flüssigkeit folgende Merkmale: eine Halteeinrichtung für das Substrat, die ausgebildet ist, das Substrat so fixieren, dass von der Oberfläche des Substrates und der Halteeinrichtung ein Prozessvolumen gebildet wird; eine Benetzungseinrichtung, die ausgebildet ist, um die Flüssigkeit in das Prozessvolumen auf die Oberfläche des Substrates einzubringen; und einer Taumeleinrichtung, die ausgebildet ist, um die Halteeinrichtung mit dem Substrat bezüglich einer ersten und einer zweiten Achse zu verkippen, wobei die erste und die zweite Achse in einer zur Oberfläche des Substrates parallelen Ebene angeordnet sind und relativ zu einander einen vorbestimmten Winkel bilden, um dadurch die Flüssigkeit auf der Oberfläche des Substrates zu verteilen.

Bei einigen Ausführungsbeispiele weist die Benetzungseinrichtung mehrere Einlassdüsen zum gleichzeitigen Einbringen unterschiedlicher Flüssigkeiten auf.

Bei einigen Ausführungsbeispielen wiest die Benetzungseinrichtung ferner eine Mischeinrichtung auf, die ausgebildet ist, die unterschiedlichen Flüssigkeiten zu vermischen.

Bei einigen weiteren Ausführungsbeispielen ist die Benetzungseinrichtung ausgebildet, um eine oder mehrere der folgenden Reagenzien in das Prozessvolumen einzubringen: Amoniakwasser, Kadmiumsulfat, Kadmiumazetat, Thioharnstoff oder VE-Wasser.

Bei einigen Ausführungsbeispiele ist die Halteeinrichtung ausgebildet, um ein flächiges Substrat zu fixieren, bei dem die laterale Ausdehnungen mindestens zehnmal größer ist als die Dicke des Substrates.

Bei einigen Ausführungsbeispielen ist die Halteeinrichtung ausgebildet ist, ein Glassubstrat zu fixieren.

Bei einigen Ausführungsbeispielen ist die Halteeinrichtung ausgebildet, Substrate mit variierender Dicke aus einem vorbestimmten Dickenbereich zu fixieren.

Bei einigen Ausführungsbeispielen ist die Halteeinrichtung öffen- und schließbar und ausgebildet, um in einem geöffneten Zustand der Halteeinrichtung das Entnehmen des Substrates aus der Halteeinrichtung und das Zuführen des Substrates in die Halteeinrichtung zu ermöglichen.

Einige Ausführungsbeispiele weisen zusätzlich eine Entleervorrichtung auf, die ausgebildet ist, um ein Entleeren der Flüssigkeit aus dem Prozessvolumen zu ermöglichen.

Bei einigen Ausführungsbeispielen weist die Entleervorrichtung ein Ventil und eine Schwenkeinrichtung zum Schwenken der Halteeinrichtung auf, wobei das Ventil so im Prozessvolumen angeordnet ist, dass bei Erreichen eines vorbestimmten Schwenkwinkels die Flüssigkeit aus dem Prozessvolumen durch das Ventil fließen kann.

## Patentansprüche

1. Vorrichtung zum gleichmäßigen Bedecken einer Oberfläche eines Substrates (10; 22) mit einer Flüssigkeit, mit folgenden Merkmalen:
einer Halteeinrichtung (12a, 12b; 20a, 20b) für das Substrat (10; 22), die ausgebildet ist, das Substrat (10; 22) so fixieren, dass von der Oberfläche des Substrates (10; 22) und der Halteeinrichtung (12a; 20a) ein Prozessvolumen gebildet wird;
eine Benetzungseinrichtung (14; 50), die ausgebildet ist, um die Flüssigkeit in das Prozessvolumen auf die Oberfläche des Substrates (10; 22) einzubringen; und
einer Taumeleinrichtung (18a-18c), die ausgebildet ist, um die Halteeinrichtung (12a, 12b; 20a, 20b) mit dem Substrat (10; 22) bezüglich einer ersten und einer zweiten Achse zu verkippen, wobei die erste und die zweite Achse in einer zur Oberfläche des Substrates (10; 22) parallelen Ebene angeordnet sind und relativ zu einander einen vorbestimmten Winkel bilden, um **dadurch** die Flüssigkeit auf der Oberfläche des Substrates zu verteilen.

2. Vorrichtung gemäß Anspruch 1, bei der die Taumeleinrichtung drei unabhängig voneinander steuerbare Unterstützungseinrichtungen (18a - 18c) aufweist, die mit je einer Seite an der Halteeinrichtung angebracht sind um diese zu stabilisieren, wobei die Unterstützungseinrichtungen (18a - 18c) unabhängig voneinander eine Bewegung in einer zur Oberfläche des Substrates (10; 22) im wesentlichen senkrechten Richtung ausführen können.

3. Vorrichtung gemäß Anspruch 2, bei der die Unterstützungseinrichtungen (18a - 18c) Hydraulikstempel sind.

4. Vorrichtung gemäß Anspruch 2, bei der die Unterstützungseinrichtungen (18a - 18c) jeweils an einem rotierenden Träger exzentrisch befestigte Stößelstangen aufweisen, welche die Bewegung in der zur Oberfläche des Substrates (10; 22) im wesentlichen senkrechten Richtung ausführen.

5. Vorrichtung gemäß Anspruch 4, bei der die Unterstützungseinrichtungen (18a - 18c) derart ausgebildet sind, dass die Exzentrizität der Befestigung der Stößelstangen einstellbar ist, um einen Hub der Bewegung in der zur Oberfläche des Substrates (10; 22) im wesentlichen senkrechten Richtung zu variieren.

6. Vorrichtung gemäß einem der vorhergehenden Ansprüche, bei der die Halteeinrichtung ausgebildet ist, um das Substrat derart zu fixieren, dass in einem geschlossenen Zustand der Halteeinrichtung mindestens 95 % der Oberfläche des Substrates von der Seite des Prozessvolumens aus frei zugänglich ist.

7. Vorrichtung gemäß einem der vorhergehenden Ansprüche, bei der die Halteeinrichtung derart ausgebildet ist, um bei fixiertem Substrat ein abgeschlossenes Prozessvolumen zu bilden, so dass in einem geschlossenen Zustand der Halteeinrichtung die Flüssigkeit des Prozessvolumen nicht verlassen kann.

8. Vorrichtung gemäß einem der vorhergehenden Ansprüche, bei der die Halteeinrichtung ausgebildet ist, dass in einem geschlossenen Zustand das Substrat zwischen einen der Oberfläche des Substrates zugewandten Deckel und einen auf der Unterseite des Substrates anliegenden Grundrahmen gepresst wird.

9. Vorrichtung gemäß einem der vorhergehenden Ansprüche, die zusätzlich eine Entleervorrichtung aufweist, die ausgebildet ist, um ein Entleeren der Flüssigkeit aus dem Prozessvolumen zu ermöglichen.

10. Vorrichtung gemäß einem der vorhergehenden Ansprüche, die ferner eine Heizeinrichtung aufweist, die ausgebildet ist, um das Substrat von einer Substratanfangs-temperatur auf eine vorbestimmte Reaktionstemperatur zu erhitzen.

11. Vorrichtung gemäß Anspruch 10, bei der die Heizeinrichtung ausgebildet ist, eine Substrattemperatur des Substrates derart zu variieren, dass diese kleiner oder gleich einer Flüssigkeitstemperatur der von der Benetzungseinrichtung auf die Oberfläche des Substrates (10; 22) aufgebrachten Flüssigkeit ist.

12. Vorrichtung gemäß Anspruch 10 oder 11, bei der die Heizeinrichtung ausgebildet ist, um das Substrat von der dem Prozessvolumen abgewandten Seite zu beheizen.

13. Verfahren zum gleichmäßigen Bedecken einer Oberfläche eines Substrates mit einer Flüssigkeit, mit folgenden Schritten:
Fixieren des Substrates, so dass von der Oberfläche des Substrates und einer Halteeinrichtung ein Prozessvolumen gebildet wird;
Einbringen der Flüssigkeit in das Prozessvolumen auf die Oberfläche des Substrates; und
Verkippen der Halteeinrichtung und des Substrates bezüglich einer ersten und einer zweiten Achse, wobei die erste und die zweite Achse in einer zur Oberfläche des Substrates parallelen Ebene angeordnet sind und relativ zueinander einen vorbestimmten Winkel bilden, um **dadurch** die Flüssigkeit auf der Oberfläche des Substrates zu verteilen.

14. Verfahren gemäß Anspruch 13, mit folgendem zusätzlichen Schritt:
Heizen des Substrates von einer Substratanfangstemperatur auf eine vorbestimmte Reaktionstemperatur.

15. Verfahren gemäß Anspruch 14, bei dem das Heizen derart durchgeführt wird, dass beim Einbringen der Flüssigkeit auf die Oberfläche des Substrates eine Substrattemperatur des Substrates geringer als eine Flüssigkeitstemperatur der Flüssigkeit ist.

## Claims

1. An apparatus for smoothly covering a surface of a substrate (10; 22) with a liquid, comprising:
a holding means (12a, 12b; 20a, 20b) for the substrate (10; 22), which is implemented to fix the substrate (10; 22) such that a process volume is formed by the surface of the substrate (10; 22) and the holding means (12a; 20a);
a wetting means (14; 50) implemented to introduce the liquid into the process volume onto the surface of the substrate (10; 22); and
a swaying means (18a-18c) implemented to tilt the holding means (12a, 12b; 20a, 20b) including the substrate (10; 22) relative to first and second axes, the first and second axes being arranged in a plane parallel to the surface of the substrate (10; 22) and forming a predetermined angle relative to each other so as to thereby distribute the liquid on the surface of the substrate.

2. The apparatus as claimed in claim 1, wherein the swaying means comprises three support means (18a - 18c) which are controllable independently of one another and are mounted on the holding means with one side each so as to stabilize it, the support means (18a - 18c) being able to perform, independently of one another, a movement in a direction which is essentially perpendicular to the surface of the substrate (10; 22).

3. The apparatus as claimed in claim 2, wherein the support means (18a - 18c) are hydraulic supports.

4. The apparatus as claimed in claim 2, wherein the support means (18a - 18c) comprise push rods, each of which is eccentrically attached to a rotating carrier, the push rods performing the movement in the direction which is essential perpendicular to the surface of the substrate (10; 22).

5. The apparatus as claimed in claim 4, wherein the support means (18a - 18c) are implemented such that the eccentricity of the attachment of the push rods is adjustable to vary a stroke of the movement in the direction which is essentially perpendicular to the surface of the substrate (10; 22).

6. The apparatus as claimed in any of the previous claims, wherein the holding means is implemented to fix the substrate such that in a closed state of the holding means at least 95% of the surface of the substrate are freely accessible from the side of the process volume.

7. The apparatus as claimed in any of the previous claims, wherein the holding means is implemented to form, with the substrate fixed, a self-contained process volume so that in a closed state of the holding means the liquid cannot leave the process volume.

8. The apparatus as claimed in any of the previous claims, wherein the holding means is implemented such that in a closed state, the substrate is pressed between a lid facing the surface of the substrate and a base frame adjoining the underside of the substrate.

9. The apparatus as claimed in any of the previous claims, additionally comprising a draining device implemented to enable draining the liquid from the process volume.

10. The apparatus as claimed in any of the previous claims, further comprising a heating means implemented to heat the substrate from a substrate start temperature to a predetermined reaction temperature.

11. The apparatus as claimed in claim 10, wherein the heating means is implemented to vary a substrate temperature of the substrate such that same is smaller than or equal to a liquid temperature of the liquid applied to the surface of the substrate (10; 22) by the wetting means.

12. The apparatus as claimed in claims 10 or 11, wherein the heating means is implemented to heat the substrate from the side facing away from the process volume.

13. A method of smoothly covering a surface of a substrate with a liquid, comprising:
fixing the substrate, so that a process volume is formed by the surface of the substrate and a holding means;
introducing the liquid into the process volume onto the surface of the substrate; and
tilting the holding means and the substrate relative to first and second axes, the first and second axes being arranged in a plane parallel to the surface of the substrate and forming a predetermined angle relative to each other so as to thereby distribute the liquid on the surface of the substrate.

14. The method as claimed in claim 13, further comprising:
heating the substrate from a substrate start temperature to a predetermined reaction temperature.

15. The method as claimed in claim 14, wherein heating is performed such that when the liquid is introduced onto the surface of the substrate, a substrate temperature of the substrate is lower than a liquid temperature of the liquid.

## Revendications

1. Dispositif pour revêtir de manière uniforme d'un liquide une surface d'un substrat (10; 22), aux caractéristiques suivantes:
un moyen de maintien (12a, 12b; 20a, 20b) du substrat (10; 22) qui est réalisé de manière à fixer le substrat (10; 22) de sorte qu'il soit formé par la surface du substrat (10; 22) et le moyen de maintien (12a; 20a) un volume de procédé;
un moyen d'humidification (14; 50) qui est réalisé de manière à amener le liquide dans le volume de procédé sur la surface du substrat (10; 22); et
un moyen de culbutement (18a à 18c) qui est réalisé de manière à faire pivoter le moyen de maintien (12a, 12b; 20a, 20b) avec le substrat (10; 22) par rapport à un premier et un deuxième axe, le premier et le deuxième axe étant disposés dans un plan parallèle à la surface du substrat (10; 22) et formant entre eux un angle prédéterminé, pour répartir ainsi le liquide sur la surface du substrat.

2. Dispositif selon la revendication 1, dans lequel le moyen de culbutement présente trois moyens de support (18a à 18c) pouvant être commandés indépendamment l'un de l'autre et qui sont placés, chacun, avec une face contre le moyen de maintien, pour stabiliser ce dernier, les moyens de support (18a à 18c) pouvant effectuer indépendamment l'un de l'autre un mouvement dans une direction sensiblement perpendiculaire à la surface du substrat (10; 22).

3. Dispositif selon la revendication 2, dans lequel les moyens de support (18a à 18c) sont des empattements hydrauliques.

4. Dispositif selon la revendication 2, dans lequel les moyens de support (18a à 18c) présentent, chacun, à un support rotatif des tiges de poussoir fixées de manière excentrique qui réalisent le mouvement dans la direction sensiblement perpendiculaire à la surface du substrat (10; 22).

5. Dispositif selon la revendication 4, dans lequel les moyens de support (18a à 18c) sont réalisés de sorte que l'excentricité de la fixation des tiges de poussoir soit réglable pour faire varier la course du mouvement dans la direction sensiblement perpendiculaire à la surface du substrat (10; 22).

6. Dispositif selon l'une des revendications précédentes, dans lequel le moyen de maintien est réalisé de manière à fixer le substrat de sorte que, à l'état fermé du moyen de maintien, au moins 95 % de la surface du substrat soit librement accessible depuis le côté du volume de procédé.

7. Dispositif selon l'une des revendications précédentes, dans lequel le moyen de maintien est réalisé de manière à former, à substrat fixé, un volume de procédé clos, de sorte que, à l'état fermé du moyen de maintien, le liquide ne puisse pas quitter le volume de procédé.

8. Dispositif selon l'une des revendications précédentes, dans lequel le moyen de maintien est réalisé de sorte que, à l'état fermé, le substrat soit pressé entre un couvercle orienté vers la surface du substrat et un cadre de base en applique contre la face inférieure du substrat.

9. Dispositif selon l'une des revendications précédentes, présentant en outre un moyen de vidage qui est réalisé de manière à permettre un vidage du liquide hors du volume de procédé.

10. Dispositif selon l'une des revendications précédentes, présentant par ailleurs un moyen de chauffage qui est réalisé de manière à chauffer le substrat d'une température de substrat initiale à une température de réaction prédéterminée.

11. Dispositif selon la revendication 10, dans lequel le moyen de chauffage est réalisé de manière à faire varier la température du substrat de sorte que celle-ci soit inférieure ou égale à une température du liquide appliqué par le moyen d'humidification sur la surface du substrat (10; 22).

12. Dispositif selon la revendication 10 ou 11, le moyen de chauffage est réalisé de manière à chauffer le substrat du côté éloigné du volume de procédé.

13. Procédé pour revêtir de manière uniforme d'un liquide une surface d'un substrat, aux étapes suivantes consistant à:
fixer le substrat de sorte que par la surface du substrat et un moyen de maintien soit formé un volume de procédé;
amener le liquide dans le volume de procédé sur la surface du substrat; et
faire pivoter le moyen de maintien et le substrat par rapport à un premier et un deuxième axe, le premier et le deuxième axe étant disposés dans un plan parallèle à la surface du substrat et formant entre eux un angle prédéterminé, pour répartir ainsi le liquide sur la surface du substrat.

14. Procédé selon la revendication 13, à l'étape additionnelle suivante:
chauffer le substrat d'une température initiale de substrat à une température de réaction prédéterminée.

15. Procédé selon la revendication 14, dans lequel le chauffage est effectué de sorte que, lors de l'amenée du liquide sur la surface du substrat, une température du substrat soit inférieure à une température du liquide.
